Europäisches Patentamt

European Patent Office

Office européen des brevets

(19)

(11) Publication number: **0 194 247**
A2

## (12) EUROPEAN PATENT APPLICATION

(21) Application number: **86850076.0**

(22) Date of filing: **03.03.86**

(51) Int. Cl.⁴: **H 05 K 3/42**, H 05 K 3/12

(30) Priority: **05.03.85 SE 8501064**

(43) Date of publication of application: **10.09.86**
Bulletin 86/37

(84) Designated Contracting States: **DE FR GB IT**

(71) Applicant: **Svecia Silkscreen Maskiner AB,
S-145 81 Norsborg (SE)**

(72) Inventor: **Ericsson, Sylve Jack Donald, Tolléns väg 8,
S-147 00 Tumba (SE)**

(74) Representative: **Lindblom, Erik J., Skördevägen 88,
S-122 35 Enskede (SE)**

(54) **A screen printer adapted for providing a layer of material on the inner surface of a hole passing through a plate.**

(57) The present invention relates to a silkscreen printer for forming a coating of material on the inner wall surface of a hole passing through a plate, a card or like base. A conglomeration of coating material (23) is applied to one side of the plate (5) over the hole (10) to be coated. A suction force (11) is caused to act on the agglomerated coating material, so that the material is moved down the wall surface (10a) of the hole (10) towards the opposite side of the plate (5). The viscosity and intrinsic adhesion properties of the coating material (23) selected is such as to form a layer of the material on the inner wall surface (10a) extending between one side of the plate (5) to the other side thereof.

A device (which co-acts with 13, 14, 15) is arranged to move beneath the squeegee (4) in a manner such that the suction force will only act in a location beneath the squeegee, and thus not where a coating of material has already been applied or where such a coating shall subsequently be applied.

0194247

TITLE OF THE INVENTION:   A silkscreen printer adapted for providing a layer of material on the inner surface of a hole passing through a plate

## TECHNICAL FIELD

The present invention relates in particular to a silkscreen printer capable of providing a layer or coating of material on the inner surface of a hole passing through a plate or the like.

The invention relates in particular to a silkscreen printer which is adapted to form a material coating on the inner wall surface of a hole which passes through a plate, for example a card or board having an array of electrical conductors on both sides thereof, the printer comprising in a known manner a printing table, a stencil arranged thereabove, and a squeegee co-acting with the stencil. Means are provided which enable the plate to be registered on the printing table in a manner known per se.

The invention also relates to facilities which enable a thin electrically-conductive coating to be applied to the inner wall surface of a hole passing through the plate.

## BACKGROUND PRIOR ART

Various methods have been proposed for manufacturing printed circuit cards or cards having an array of electrical conductors printed thereon, such cards being the object of extremely rapid development within the art.

One known method  departs from an electrically insulated base which is totally covered on one side with an electrically conductive coating, which is etched away at locations where no electrical connection is desired.

Another method is to form the desired conductor pattern on one side of the base or plate with the aid of silkscreen printing.

These methods in which the array of conductors is formed on one side of the base with the aid of etching techniques and printing techniques (electrically conductive inks) enable a compact pattern of conductors to be obtained.

Cards or plates on which conductors are located on both sides thereof are also known to the art, although when the two circuits on respective sides of the card are to co-act with one another and when the circuit on one side of the card incorporates one or more connecting points which are to be connected to one or more connecting points on the other side of the card, it has been found problematic to connect the conductor array on the one side of the card to the conductor array on the other side of the card.

One known solution to this problem is to extend a desired connecting point from the conductor array on one side of the card to one edge thereof and to there form a contact surface, and to correspondingly extend a desired connecting point from the conductor array on the other side of said card to the same edge portion thereof, and there form a contact surface, and to permit mutually electrically connected contacts to act against the aforesaid contact surfaces, thereby providing an extension of the conductor array. Alternatively, the card is provided with penetrating holes whose inner wall surfaces are coated with an electrically conductive material which enable connecting points on one side of the card to be connected electrically to connecting points on the other side of the card.

In this latter respect, the two conductor arrays may be provided with a coating of protective varnish, although not in the region of the holes, and the inner wall surfaces of the holes then provided with a coating of material by means of electrolysis or some similar technique, whereafter the protective varnish is removed.

The British Patent Specification 2 030 007 describes an arrangement in which material to be printed and provided with through-passing holes is arranged to rest on a support provided with holes corresponding to the holes passing through the material to be printed, the holes in the support being in communication with a common chamber in which a subpressure prevails, such that a substance or paste (paint) placed over the material is drawn by suction through the holes therein.

In this instance the holes provided in the material are much narrower than the corresponding holes in the support means.

The German Offenlegungschrift 34 20 966 describes and illustrates a silkscreen printing method for producing electrical connecting circuits having at least one through-passing hole, wherewith an electrically conductive paste (paint) is applied to the upper surface of the circuit with the aid of a squeegee, the paste being drawn into the inner wall surface of the hole by means of subpressure acting on the opposite side of the circuit. The subpressure is maintained at a constant value within the range of 1000 to 20 000 Pa during the printing sequence.

DISCLOSURE OF THE PRESENT INVENTION
TECHNICAL PROBLEM
When reviewing the present state of this art it will be readily perceived that a qualified technical problem is one of enabling the inner wall surface of a through-passing hole provided in a plate or like base to be readily coated with a layer of material in a controllable manner.

A more qualified technical problem in this respect is one of enabling the inner wall surface of a hole passing through a card having an array of conductors on both sides thereof to be coated with a thin layer of material so that sub-

4 0194247

stantially solely the inner wall surface of the hole is covered by the layer of material while adapting the prevailing subpressure for respective holes.

Another qualified technical problem is one of providing means whereby an agglomeration of material intended to form said coating or layer and pressed into agglomeration by means of a squeegee can be caused to pass through a particular part in the stencil towards the other side of the plate or card and down along the inner wall surface of the hole to be coated in a direction towards the surface of the card remote from the printing table, this displacement of the agglomerating material being effected so that the inner wall surface of the hole is coated with a layer of said material.

A further technical problem in this respect is one of providing means which ensure that the subpressure will only act on the hole whose inner wall surface is to be coated, which in practice means that the subpressure effect shall accompany the movement of the squeegee and be located immediately adjacent to and solely beneath the squeegee, so that the inner wall surfaces of holes which have already been coated and the inner surfaces of walls not yet coated are not effected by the subpressure.

SOLUTION

The present invention affords a solution to the aforesaid technical problems by using primarily a silkscreen printer which is adapted to form a coating of material on the inner wall surface of a hole passing through a plate, for example a card or board having an array of conductors on both sides thereof, the printer comprising a printing table, a stencil located thereabove, and a squeegee arrangement arranged to co-act with the stencil, the plate being placed in a registered position on the printing table. The stencil is provided with pervious parts through which the coating material can penetrate and which are located above respective holes, and the squeegee is arranged to press an agglomeration of said coating material through respective pervious   parts of the stencil.

The aforesaid agglomeration of coating material is caused to move along the wall surface of the hole in a direction towards the surface of the plate remote from the printing table. The silkscreen printer includes a matrix in which passages are provided, these passages being arranged in a pattern corresponding to the pattern of the holes in the plate. Means are provided for placing the passages under a suction force in order to cause coating material to pass through the pervious parts of the stencil.

In accordance with the invention the holes provided in the plate are arranged to co-act with a printing table in which a part placed under a small subpressure can be displaced synchronously with the squeegee displacement.

According to a further embodiment of the invention, a part in which an overpressure prevails is located downstream of the aforesaid part  in which a subpressure prevails when seen in the direction of displacement.

The coating material may be an electrically insulating or an electrically conductive viscous fluid.

The part in which a subpressure prevails may suitably be divided into two sections, where the subpressure of one section is lower than the subpressure of the other section.

ADVANTAGES
The advantages primarily afforded by a silkscreen printer according to the invention reside in the provision of means which enable a coating of material to be formed on the inner wall surface of a hole passing through a plate, a card or like base in a simple and readily controlled manner.

---------------

The primary characteristic features of a silkscreen
printer according to the present invention are set forth
in the characterizing clause of the following Claim 1.

------------

BRIEF DESCRIPTION OF THE DRAWINGS

An embodiment of a silkscreen printer at present preferred
and having features significant of the present invention
will now be described in more detail with reference to the
accompanying drawings, in which

Figure 1 is a greatly simplified view in perspective of
those components of a silkscreen printer essential
in obtaining an understanding of the invention;

Figure 2 is a sectional view taken on the line II-II in
Figure 1;

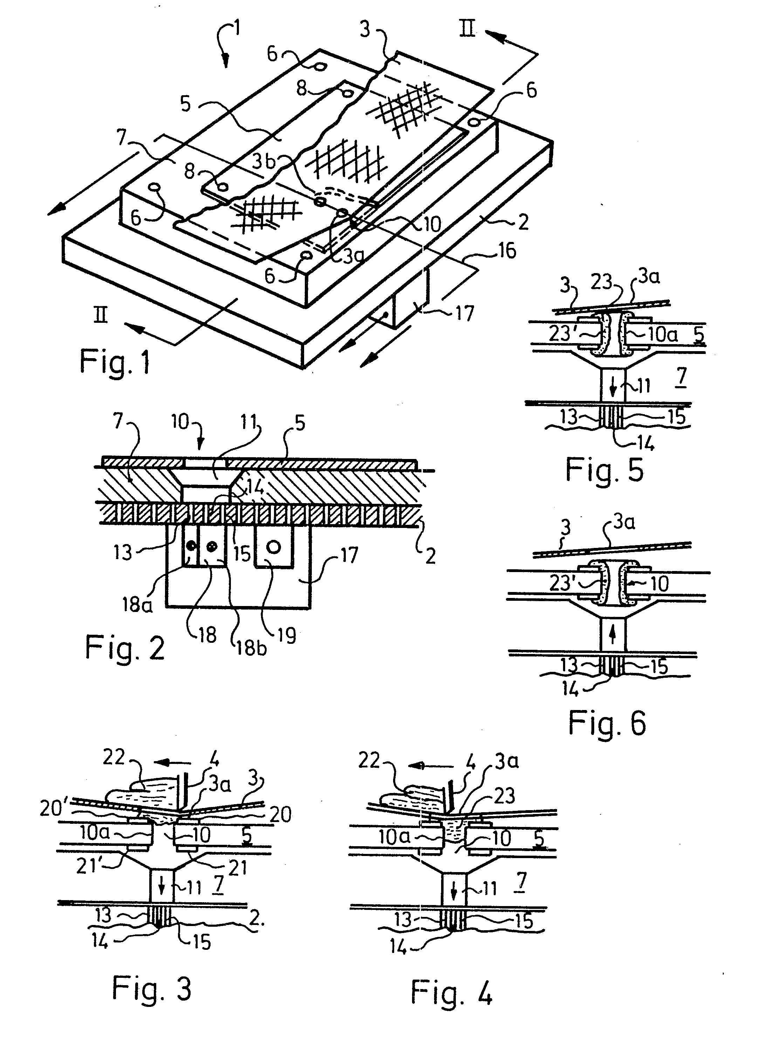

Figure 3 illustrates schematically the first stage of an
operational sequence according to the invention;

Figure 4 illustrates a second stage in the operational
sequence;

Figure 5 illustrates a third stage in the operational sequence of events according to the invention; and

Figure 6 illustrates a fourth stage in the sequence of
operations when utilizing the coating technique
according to the invention.

DESCRIPTION OF AN EMBODIMENT AT PRESENT PREFERRED

Figure 1 is a greatly simplified illustration of a silkscreen printer 1 adapted to coat the inner wall surface of
a through-passing hole in a plate with a coating of material, the plate of the illustrated embodiment being presumed to have the form of a printed circuit card 5 having
an array of electrical conductors on both sides thereof.

The printer 1 comprises a printing table 2 having a
stencil 3 positioned thereabove. The stencil is intended to co-act with a squeegee arrangement, which has not been shown in Figure 1 for reasons of clarity. The squeegee, however, is shown in Figures 3 and 4 and is there referenced 4.

Arranged on the printing table 2 is a matrix 7 on which the card or plate 5 rests in a registered position thereon. The position of the matrix 7 is related precisely to the printing table 2 through the agency of registering devices 6 in the form of pins and corresponding holes, while the card 5 is related precisely to the matrix 7 through the agency of pins and corresponding holes 8.

It is assumed that the card 5 had previously been provided on one side thereof with a first array of electrical conductors, and a second array of electrical conductors on the other side thereof, for example by means of a printing process carried out in a silkscreen printer.

It is also assumed that the card has been provided with one or more holes for connecting corresponding connecting points of the first and the second conductor arrays, and that the inner wall surfaces of the hole or holes is, or are, to be provided with an electrically conductive coating, for electrical connection with both of the aforesaid connection points.

The present invention provides simple means for coating the inner wall surface of a hole with an electrically conductive layer.

It will be understood that the invention can be applied to form a thin layer of material on all holes in a card during one and the same printing process in a silkscreen printer. However, for the sake of clarity only two pervious stencil-portions 3a,3b through which coating material can pass are shown on the illustrated stencil 3, and the following description is made in this regard solely with reference to the pervious stencil-portion 3a and a hole 10 relating to said pervious stencil-portion.

The stencil 3 is thus provided with one or more pervious portions 3a,3b, each of which is intended to be positioned over a respective hole in the card 5, the inner walls of which holes are to be coated with a thin layer of material.

Referring to Figure 2, the pervious stencil-portion 3a shall lie immediately over the hole 10 in the card 5. This can best be seen from Figures 3 and 4.

Arranged in the matrix 7 is a channel 11, which is intended to lie immediately beneath the hole 10 in the card 5, when the card rests against and positioned on the matrix, as illustrated in Figure 2. The channel 11 has a funnel-shaped upper portion, with the remainder of the channel being of substantially uniform cross-section.

The printing table 2 is provided in a known manner with a plurality of through-passing passages, of which those referenced 13,14 and 15 are positioned so as to co-operate with the channel 11 in the matrix 7.

In Figure 1 the position of the squeegee is identified by a line 16, which can be assumed to move from right to left in Figure 1 as the squeegee moves along the stencil. A device 17 arranged beneath the printing table 2 moves synchronously with the movement of the squeegee along the stencil 3, in the direction of the arrows shown.

As will be seen from Figure 2, the device 17 comprises a chamber 18 in which a subpressure prevails, and a chamber 19 in which an overpressure prevails. The chamber 18 can be divided, as illustrated, into a first part-chamber 18a and a following part-chamber 18b, the subpressures in the two part-chambers being of mutually different values. For example, the subpressure prevailing in the part-chamber 18a may be lower than that prevailing in the part-chamber 18b.

A sequence of operational stages in which a thin layer of material is coated on the inner wall surface of a through-passing hole in a card having arrays of conductors on both sides thereof will now be described with reference to Figures 3-6.

Figure 3 illustrates the card 5 provided with the aforesaid hole 10 and having a first array of conductors 20,20' on one side of the card and a second array of conductors 21,21' on the other side thereof. The passages 13,14 and 15 in the printing table 2 are shown positioned immediately beneath the channel 11 in the matrix 7.

In the initial stage of a coating sequence, illustrated in Figure 3, the squeegee 4 has the position illustrated in the figure, immediately adjacent the hole 10, and coating material in the form of a viscous fluid 22 is moved along the stencil 3 in the direction of the arrow, by means of the squeegee 4.

In this stage of the operational sequence the passage 15 is assumed to communicate with the chamber, or part-chamber 18a under subpressure, so that the coating material 22 is drawn by suction through the pervious stencil-portion 3a, into the hole 10 along part of its depth.

Figure 4 illustrates a later stage in which an agglomeration 23 of the viscous material 22 has passed through the pervious stencil-portion 3a. It is now assumed that the part-chamber 18a co-operates with the passage 14, while the part-chamber 18b co-operates with the passage 15, thereby creating a somewhat higher subpressure in the hole 10.

As the squeegee 4 pushes the viscous coating material 22 over the pervious stencil-portion 3a, some of said material will pass down therethrough, the actual amount of material entering the hole 10 being dependent on the level of subpressure, the viscosity of the coating material, the intrinsic adhesion properties of said material, the ability of the material to adhere to the upper surface of the card 5, the size and shape of the hole 10, the speed at which the squeegee moves, etc.. The amount of coating material drawn into the hole 10 shall be adapted through the agency of one or more of the aforesaid parameters, so as to be sufficient to form a thin coating on the inner wall surface 10a of said hole.

In the operational stage illustrated in Figure 5, the agglomeration 23 of viscous coating material 22 is coated on the inner surface 10a of the hole 10 and all passages 13,14 and 15 are assumed to be subjected to the subpressure of both part-chambers 18a and 18b.

It is possible that a downstream of air in solely one direction would result in an excessive quantity of coating material at the bottom surface of the card 5. With this in mind, and also for other reasons, it is preferred to connect the chamber 19 with the passages 13,14 and 15, so as to cause a flow of pressurized air to pass through the hole 10 in the opposite direction.

The material forming the coating 23' is an electrically insulating or an electrically conductive viscous fluid; it is important when choosing the coating material that its viscosity, intrinsic adhesive properties etc. will enable a thin coating to be formed on the inner surface 10a of the hole 10, between the mutually opposite sides of the card 5.

The invention is not restricted to the illustrated and described embodiment, and modifications can be made within the scope of the following claims.

0194247

## CLAIMS

1. A silkscreen printer adapted for applying a coating of material to the inner surface of a hole passing through a plate, for example a circuit card or board having an array of conductors on both sides thereof, the printer comprising a printing table, a stencil positioned thereabove, and a squeegee means arranged to co-act with the stencil, and locating means for registering the plate on the printing table, the stencil incorporating a pervious portion which enables coating material to penetrate the stencil and which is intended to lie over a respective hole in said plate, and in which printer the squeegee is arranged to press an agglomeration of coating material through said pervious stencil-portion, this agglomeration of coating material being caused to move along the wall surface of the hole towards the side of the plate remote from the printing table, the plate being located on a matrix having provided therein channels which are so positioned in relation to corresponding holes in the plate that said channels in the matrix can be placed under subpressure when an agglomeration of coating material is to be drawn through the pervious stencil-portion, characterized in that the holes in said plate are arranged to be brought into communication with a member on the printing table which is placed under a slight subpressure and which is arranged to move synchronously with the squeegee means.

2. A silkscreen printer according to Claim 1, characterized in that a member placed under overpressure is located rearwardly of the underpressure component as seen in the displacement direction.

3. A silkscreen printer according to Claim 1 or 2, characterized in that the coating material is an electrically insulating or an electrically conductive viscous fluid.

4. A silkscreen printer according to Claim 1, characterized in that the member through which a subpressure is created comprises two compartments where the subpressure prevailing in one compartment is lower than the subpressure prevailing in the other compartment.

Fig. 1

Fig. 2

Fig. 3

Fig. 4

Fig. 5

Fig. 6

1/1

0194247